# EUROPEAN PATENT SPECIFICATION

(11) **EP 1 470 176 B1**
(45) Date of publication and mention of the grant of the patent: **27.06.2007**
(21) Application number: 03734967.7
(22) Date of filing: 21.01.2003
(51) Int. Cl.: C08G 59/40, H01L 21/56

(54) **NO FLOW UNDERFILL COMPOSITION**
NICHTFLIESSENDE UNTERFÜLLUNGSZUSAMMENSETZUNG
COMPOSITION DE REMPLISSAGE SOUS-JACENT SANS ECOULEMENT

(30) Priority: 31.01.2002 US 62902
(43) Date of publication of application: 27.10.2004
(73) Proprietor: National Starch and Chemical Investment Holding Corporation, Wilmington, Delaware 19803-7663 (US)
(72) Inventor: XIAO, Yue, Belle Mead, NJ 08502 (US); TONG, Quinn, K., Belle Mead, NJ 08502 (US); MORGANELLI, Paul, Upton, MA 01568 (US); SHAH, Jayesh, Plaistow, NH 03865 (US)
(74) Representative: Held, Stephan
(86) International application number: PCT/US2003/001676
(87) International publication number: WO 2003/064493

(56) References cited:
- WO-A-98/37134
- PATENT ABSTRACTS OF JAPAN vol. 017, no. 025 (C-1017), 18 January 1993 (1993-01-18) & JP 04 248827 A (MATSUSHITA ELECTRIC WORKS LTD), 4 September 1992 (1992-09-04)
- PATENT ABSTRACTS OF JAPAN vol. 1997, no. 06, 30 June 1997 (1997-06-30) & JP 09 031163 A (SHIN ETSU CHEM CO LTD), 4 February 1997 (1997-02-04)
- DATABASE WPI Week 197421 Derwent Publications Ltd., London, GB; AN 1974-38938v XP002240817 & JP 48 077000 A 16 October 1973 (1973-10-16)
- PATENT ABSTRACTS OF JAPAN vol. 013, no. 061 (C-567), 10 February 1989 (1989-02-10) & JP 63 251420 A (SHIN ETSU CHEM CO LTD), 18 October 1988 (1988-10-18)

## Description

### FIELD OF THE INVENTION

The present invention relates to an underfill encapsulant that may be utilized in no-flow underfilling processes.

### BACKGROUND OF THE INVENTION

This invention relates to underfill encapsulant compounds prepared from epoxies to protect and reinforce the interconnections between an electronic component and a substrate in a microelectronic device. Microelectronic devices contain multiple types of electrical circuit components, mainly transistors assembled together in integrated circuit (IC) chips, but also resistors, capacitors, and other components. These electronic components are interconnected to form the circuits, and eventually are connected to and supported on a carrier or a substrate, such as a printed wire board. The integrated circuit component may comprise a single bare chip, a single encapsulated chip, or an encapsulated package of multiple chips. The single bare chip can be attached to a lead frame, which in turn is encapsulated and attached to the printed wire board, or it can be directly attached to the printed wire board.

Whether the component is a bare chip connected to a lead frame, or a package connected to a printed wire board or other substrate, the connections are made between electrical terminations on the electronic component and corresponding electrical terminations on the substrate. One method for making these connections uses polymeric or metallic material that is applied in bumps to the component or substrate terminals. The terminals are aligned and contacted together and the resulting assembly is heated to reflow the metallic or polymeric material and solidify the connection.

During its normal service life, the electronic assembly is subjected to cycles of widely varying temperature ranges. Due to the differences in the coefficient of thermal expansion for the electronic component, the interconnect material, and the substrate, this thermal cycling can stress the components of the assembly and cause it to fail. To prevent the failure, the gap between the component and the substrate is filled with a polymeric encapsulant, hereinafter called underfill or underfill encapsulant, to reinforce the interconnect material and to absorb some of the stress of the thermal cycling. In addition, the material helps absorb impact energy and improve so-called "drop test performance.

Two prominent uses for underfill technology are for reinforcing packages known in the industry as chip scale packages (CSP), in which a chip package is attached to a printed wire board, and flip-chip ball grid array (BGA) in which a chip is attached by a ball and grid array to a printed wire board.

In conventional capillary flow underfill applications, the underfill dispensing and curing takes place after the reflow of the metallic or polymeric interconnect. In this procedure, flux is initially applied on the metal pads on the substrate. Next, the chip is placed on the fluxed area of the substrate, on top of the soldering site. The assembly is then heated to allow for reflow of the solder joint. At this point, a measured amount of underfill encapsulant material is dispensed along one or more peripheral sides of the electronic assembly and capillary action within the component-to-substrate gap draws the material inward. After the gap is filled, additional underfill encapsulant may be dispensed along the complete assembly periphery to help reduce stress concentrations and prolong the fatigue life of the assembled structure. The underfill encapsulant is subsequently cured to reach its optimized final properties.

The no-flow underfill process provides a more efficient procedure than that described above for attaching electronic components to a substrate and protecting the assembly with an underfill encapsulant. In the no-flow encapsulation process the flux is contained in the underfill which is applied to the assembly site prior to the component placement. After the component is placed, it is soldered to the metal pad connections on the substrate by passing the full assembly, comprising the component, underfill and substrate, through a reflow oven. During this process the underfill fluxes the solder and the metal pads, the solder joint reflows, and the underfill cures. Thus, the separate steps of applying the flux and post-curing the underfill are eliminated via this process.

As soldering and cure of the underfill occur during the same step of the process, maintaining the proper viscosity and cure rate of the underfill material is critical in the no-flow encapsulation process. The underfill must remain at a low viscosity to allow melting of the solder and the formation of the interconnections. It is also important that the cure of the underfill not be unduly delayed after the cure of the solder. It is desirable that the underfill in the no-flow process cure rapidly after the melting of the solder. Preferably the viscosity will be suitable to allow the underfill to be dispensed from a syringe.

Most commercially available underfill encapsulants utilize epoxy anhydride chemistry. For example, U.S. Patent No. 6,180,696 describes an underfill that contains a separate anhydride component. In certain instances, the use of anhydrides in underfills has raised toxicity issues. Accordingly, it would be preferable to develop an underfill encapsulant that does not contain a free anhydride component. Preferably, the system is fully cured after the completion of the reflow process.

### BRIEF DESCRIPTION OF THE DRAWINGS

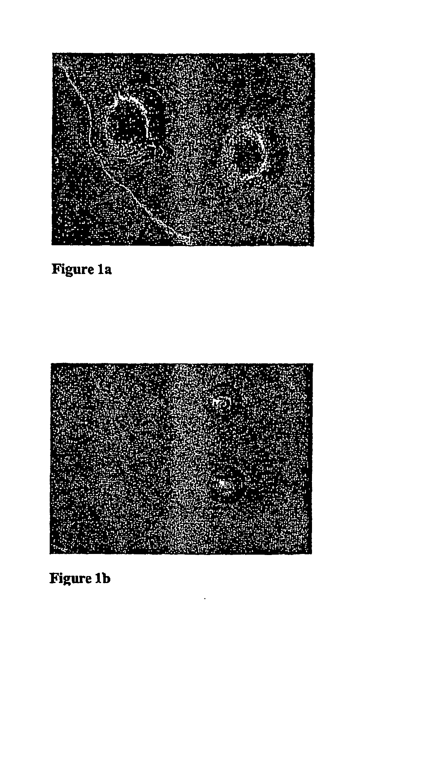

**Figure 1a** is an image of a eutectic solder ball after fluxing using the formulation of the underfill having an imidazole-anhydride adduct.
**Figure 1b** is an image of a eutectic solder ball after fluxing using the formulation of the underfill having a physical blending of imidazole and anhydride.

### SUMMARY OF THE INVENTION

The invention relates to a curable underfill encapsulant composition which is especially useful in the no-flow encapsulation process. The composition contains a thermal curable resin system comprising an admixing of at least one epoxy resin and a phenol-containing compound, such as a phenol or phenolic resin, an imidazole-anhydride adduct as a catalyst, and a fluxing agent. Various additives, such as air release agents, flow additives, adhesion promoters and rheology modifiers may also be added as desired.

### DETAILED DESCRIPTION OF THE INVENTION

The resins used in the underfill encapsulant composition of the present invention are curable compounds, which means that they are capable of polymerization. As used in this specification, to cure will mean to polymerize, with cross-linking. Cross-linking, as understood in the art, is the attachment of two polymer chains by bridges of an element, a molecular group, or a compound, and in general takes place upon heating.

Ingredients of the underfill encapsulant composition of the present invention include an admixture of one or more epoxy resins and a phenol-containing compound such as phenol or phenolic resin, an imidazole-anhydride adduct which acts as a catalyst, and a fluxing agent. Optionally, air release agents, flow additives, adhesion promoters, rheology modifiers, surfactants and other ingredients may be included. The ingredients are specifically chosen to obtain the desired balance of properties for the use of the particular resins.

Examples of epoxy resins suitable for use in the present underfill composition include monofunctional and multifunctional glycidyl ethers of Bisphenol-A and Bisphenol-F, aliphatic and aromatic epoxies, saturated and unsaturated epoxies, or cycloaliphatic epoxy resins or a combination thereof. Examples of aliphatic epoxy include Flex Epoxy 1.

Flex Epoxy 1 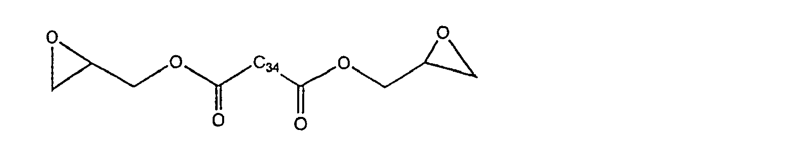 Example of aromatic epoxies include RAS-1, RAS-5, and Flex Epoxy-3. 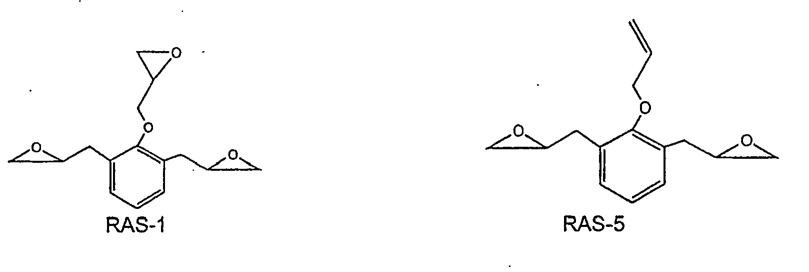 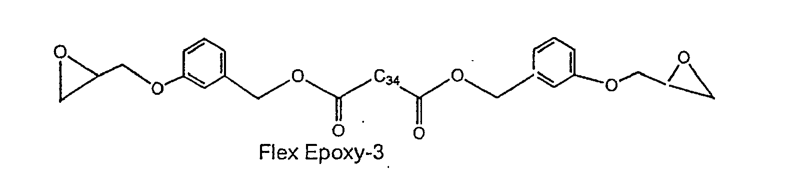 Example of unsaturated epoxy includes Cardolite NC513.

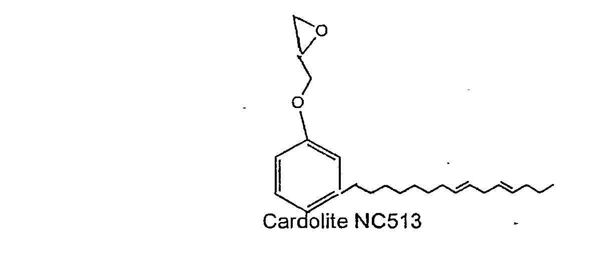

Examples of non-glycidyl ether epoxides include 3,4-epoxycyclohexylmethyl-3,4-epoxycyclohexane carboxylate, which contains two epoxide groups that are part of the ring structures and an ester linkage, vinylcyclohexene dioxide, which contains two epoxide groups and one of which is part of the ring structure, 3,4-epoxy-6-methyl cyclohexyl methyl-3,4-epoxycyclohexane carboxylate and dicyclopentadiene dioxide.

Glycidyl ether epoxides are preferred in the invention, either separately or in combination with the non-glycidyl ether epoxides. A preferred epoxy resin of this type is bisphenol A resin. Another preferred epoxy is aliphatic epoxy including Flex-1 epoxy. A most preferred epoxy resin is bisphenol F type resin. These resins are generally prepared by the reaction of one mole of bisphenol F resin and two moles of epichlorohydrin. A further preferred type of epoxy resin is epoxy novolac resin. Epoxy novolac resin is commonly prepared by the reaction of phenolic resin and epichlorohydrin. A preferred epoxy novolac resin is poly(phenyl glycidyl ether)-co-formaldehyde. Biphenyl type epoxy resin may also be utilized in the present invention. This type of resin is commonly prepared by the reaction of biphenyl resin and epichlorohydrin. Dicyclopentadiene-phenol epoxy resin, naphthalene resins, epoxy functional butadiene acrylonitrile copolymers, epoxy functional polydimethyl siloxane and mixtures thereof are additional types of epoxy resins which may be employed. Commercially available bisphenol-F type resin are available from CVC Specialty Chemicals, Maple Shade, New Jersey, under the designation 8230E and Resolution Performance Products LLC under the designation RSL1739. Bisphenol-A type epoxy resin is commercially available from Resolution Technology as EPON 828, and a blend of bisphenol-A and bisphenol-F is available from Nippon Chemical Company under the designation ZX-1059.

The desired phenol-containing compound, such as phenol or phenolic resin, is combined with the non-phenolic resin to produce the admixture. Especially preferred phenolic resins are phenolic novolac resins. Especially preferred phenol are bisphenol-A and dially bisphenol A phenolic resins. Commercially available examples of phenolic novolac resins are Durez 12686 (Oxychem), HRJ -2190 (Schenectady), SP-560 (Schenectady), HRJ-2606 (Schenectady), HRJ-1166 (Schenectady), HRJ-11040 (Schenectady), HRJ-2210 (Schenectady), CRJ-406 (Schenectady), HRJ-2163 (Schenectady), HRJ-10739 (Schenectady), HRJ-13172 (Schenectady), HRJ-11937 (Schenectady), HRJ-2355 (Schenectady), SP-25 (Schenectady), SP-1068 (Schenectady), CRJ-418 (Schenectady), SP-1090 (Schenectady), SP-1077 (Schenectady). SP-6701 (Schenectady), HRJ-11945 (Schenectady), SP-6700 (Schenectady), HRJ-11995 (Schenectady), SP-553 (Schenectady), HRJ-2053 (Schenectady), SP-560 (Schenectady), BRWE5300 (Georgia-Pacific Resins), BRWE5555 (Georgia-Pacific Resins), and GP2074 (Georgia-Pacific Resins).

In addition to the resins, an imidazole-anhydride adduct is included in the underfill composition as a catalyst. The adduct provides different properties to the underfill than the properties provided by the inclusion of imidazole and anhydride as separate components. Preferred imidazoles that may be included in the adduct include non-N-substituted imidazoles such as 2-phenyl-4-methyl imidazole, 2-phenyl imidazole and imidazole. Other useful imidazole components include alkyl-substituted imidazole, N-substituted imidazole and mixtures thereof. The adduct also comprises an anhydride component. The preferred anhydride is preferably a cycloaliphatic anhydride and most preferably pyromellitic dianhydride, commercially available as PMDA from Aldrich. Additional preferred anhydrides include methylhexa-hydro phthalic anhydride, commercially available as MHHPA from Lonza Inc. Intermediates and Actives. Other anhydrides that may be utilized include methyltetra-hydrophthalic anhydride, nadic methyl anhydride, hexa-hydro phthalic anhydride, tetra-hydro phthalic anhydride, phthalic anhydride, dodecyl succinic anhydride, bisphenyl dianhydride, benzophenone tetracarboxylic dianhydride, and mixtures thereof.

A fluxing agent is also incorporated into the underfill composition. The fluxing agent primarily removes metal oxides and prevents reoxidation. While many different fluxing materials may be employed, the fluxing agent is preferably chosen from the group carboxylic acids. These carboxylic acids include Rosin Gum, dodecanedioic acid (commercially available as Corfree M2 from Aldrich), adipic acid, tartaric acid, and citric acid. The flux agent may also be chosen from the group that includes alcohols, hydroxyl acid and hydroxyl base. Preferable fluxing materials include polyols such as ethylene glycol, glyercol, 3-[bis(glycidyl oxy methyl) methoxy]-1,2-propane diol, D-ribose, D-cellobiose, cellulose, 3-cyclohexene-1,1-dimethanol, and similar materials.

Additional ingredients may be added to the underfill encapsulant to produce a composition with the desired properties. For example, monofunctional reactive diluents can incrementally delay the increase in viscosity without adversely affecting the physical properties of the cured underfill. Preferred diluents include p-tert-butyl-phenyl glycidyl ether, allyl glycidyl ether, glycerol diglycidyl ether, glycidyl ether of alkyl phenol (commercially available from Cardolite Corporation as Cardolite NC513), and Butanediodiglycidylether (commercially available as BDGE from Aldrich), although other diluents may be utilized. Surfactants may be utilized to aid in the prevention of process voiding during the flip-chip bonding process and subsequent solder joint reflow and material curing. Various surfactants which may be utilized include organic acrylic polymers, silicones, polyoxyethylene/polyoxypropylene block copolymers, ethylene diamine based polyoxyethylene/polyoxypropylene block copolymers, polyol-based polyoxyalkylenes, fatty alcohol-based polyoxyalkylenes, fatty alcohol polyoxyalkylene alkyl ethers and mixtures thereof. In addition, coupling agents, air release agents, flow additives, adhesion promoters and other ingredients may also be added as desired.

A preferred embodiment of the underfill encapsulant of the present invention comprises an admixture of at least one epoxy resin and at least one phenol/phenolic resin as a cross-link agent, an imidazole-anyhydride adduct as a catalyst, a fluxing agent and other ingredients as desired. The resin admixture will comprise in the range of about 0.1 wt % to about 99.9 wt % of the epoxy resin and about 0.1 to about 99.9 wt % of the phenolic resin. Preferably, the admixture will be comprised of in the range of about 40 wt % to about 95 wt % of the epoxy resin and about 5 to about 60 wt % of the phenol/phenolic resin. The admixture will comprise in the range of about 80 wt % to about 99.9 wt % of the underfill composition. An imidazole-anhydride adduct is also added as a catalyst. The adduct comprises in the range about 0.01 wt % to about 10 wt % of the underfill composition and preferably about 0.1 wt % to about 5 wt % of the composition. A fluxing agent is added comprising in the range of about 0.5 wt % to about 20 wt % of the composition and preferably in the range of about 1 wt % to about 10 wt % of the composition. Finally, optional ingredients such as surfactants, air release agents, flow additives, rheology modifiers, and adhesion promoters may be added to the composition in the range of about 0.01 wt % to about 5 wt % of the composition.

The invention may be better understood by reference to the following examples:
EXAMPLE 1: Six underfill compositions were formulated utilizing Bisphenol F epoxy (RSL1739), phenolic epoxy (HRJ1166), 2-phenyl-4-methyl imidazole (2P4MZ) and pyromellitic dianhydride (PMDA) both as an adduct and as separate components. For each composition, the epoxy and phenolic resins were weighed and placed inside a glass jar. The glass jar was heated on a 150 °C hot plate to achieve mixing of the resins. The samples were then cooled to ambient temperature. The remaining components, including catalysts, fluxing agent, and air release agent were added to the glass jars. The samples were thoroughly mixed using a wooden stick and then degassed in a vacuum oven. The molar ratio of the PMDA to 2P4MZ is 1:2, which is the same as the molar ratio of the PMDA and the 2P4MZ in the adduct. The formulations are set out in Table 1.

**Table 1: Underfill formulations**

| | Bis-F Epoxy | Phenolic HRJ1166 | 2P4MZ-PMDA Adduct | PMDA | 2P4MZ | Corfree M2 |
|---|---|---|---|---|---|---|
| A1 | 100 | | 0.5 | | | |
| A2 | 100 | | | 0.204 5 | 0.2955 | |
| B1 | 90 | 10 | 0.5 | | | |
| B2 | 90 | 10 | | 0.204 5 | 0.2955 | |
| C1 | 90 | 10 | 0.5 | | | 10 |
| C2 | 90 | 10 | | 0.204 5 | 0.2955 | 10 |

The curing behavior of each formulation was characterized using a Differential Scanning Calorimeter (DSC). Table 2 lists the results of the curing peak and enthalpy for each formulation. The experiments were repeated four times with a standard deviation of 0.8°C on peak temperature.

**Table 2: Curing Behavior of Underfill Formulations**

| | Peak Temp. °C | ΔH (J/g) |
|---|---|---|
| A1 | 190.5 | 25.5 |
| A2 | 152.9 | 5.3 |
| B1 | 169.0 | 190.6 |
| B2 | 156.9 | 150.3 |
| C1 | 180.2 | 222.3 |
| C3 | 173.7 | 227.2 |

The results set out in Table 2 clearly illustrate the difference in the curing behavior between underfills which contain an imidazole-anhydride adduct as a catalyst and those, that are otherwise identical, containing a physical blend of imidazole and anhydride.

Compositions C1 and C2 were also tested for its capability for fluxing. A drop of each formulation was dispensed on an OSP Cu substrate and a 20 mil eutectic solder ball was put into the liquid drop. The entire package was heated on a 150°C hot plate for two minutes and then transferred to a 240°C hot plate. Capability of fluxing was determined by observation of the solder ball enlargement on the 240°C hot plate. As shown in Figures 1a and 1b, the solder ball enlargement using formulation C1, containing the imidazole-anhydride adduct, was much greater than the size of the solder ball formed using formulation C2, containing the physical blending of the imidazole and anhydride. This larger solder ball formed by formulation C1 indicates that the solder ball is much easier to flux using the imidazole-anhydride adduct.
EXAMPLE 2: Six underfill composition formulations were made according to the procedure set out in Example 1. The epoxy utilized in each formulation was either RSL1739, Flex-1 epoxy or a blend of RSL1739 and a second epoxy. In addition to the epoxy, HRJ1166 was included for the phenolic component, a 2P4MZ-PMDA imidazole-anhydride adduct catalyst and a fluxing agent of dodecanedioic acid (Corfree M2) were also added to the composition. The viscosity of each composition was tested and the results are listed in Table 3.

**Table 3: Viscosity of epoxy/phenolic/imidazole-anhydride adduct underfills**

| | Epoxy (g) | Phenolic HRJ1166 (g) | 2P4MZ-PMDA Adduct (g) | Corfree M2 (g) | Viscosity (cp) |
|---|---|---|---|---|---|
| C1 | RSL1739 90 | 10 | 0.5 | 10 | 16091 |
| D | RSL1739 85 NC513 5 | 10 | 0.5 | 10 | 7474 |
| E | RSL1739 85 BDGE 5 | 10 | 0.5 | 10 | 5831 |
| F | Flex-1 80 | 20 | 3 | 10 | 6158 |
| G | RSL1739 45 Flex-1 45 | 10 | 1 | 10 | 3075 |
| H | RSL1739 70 Flex-1 20 | 10 | 0.5 | 10 | 6493 |

As illustrated in Table 3, the viscosity of each underfill composition containing the imidazole-anhydride adduct was under 20,000 cps which allows for good dispensing through a syringe.
EXAMPLE 3: It is preferable for underfill compositions to have a curing reaction that occurs at a temperature near the 183°C melting point of eutectic Sn/Pb solder bumps. Minimal curing should ideally occur below the melting temperature of the solder bump and, to allow complete curing in one reflow process, a rapid curing reaction should take place at a temperature just higher than the melting temperature of the solder ball. The underfill compositions of Example 2 were characterized using a DSC and the results are illustrated in Table 4.

**Table 4: DSC Results of the Underfill Compositions**

| | Peak Temperature (°C) | ΔH (J/g) |
|---|---|---|
| C2 | 180.2 | 222.3 |
| D | 181.4 | 227.7 |
| E | 181.7 | 230.4 |
| F | 179.7 | 139.2 |
| G | 184.04 | 157.5 |
| H | 182.4 | 271.4 |

As illustrated in Table 4, the peak temperature of the formulations containing the imidazole-anhydride adduct are generally in the range of 180°C to 185°C which is a good indication that the curing of the underfill composition is delayed sufficiently to allow the solder ball to melt before the cross-linking network forms.

The capability of fluxing of the compositions of Example 3 was tested using the hot plate method set out in Example 1, except two different substrates, an OSP Cu substrate and a Ni/Au substrate, were utilized. All of the formulations in Table 3 exhibited enlargement of the solder bumps in the range of about 100% to about 300% which indicates that the underfills provide excellent capability of fluxing. At the same time, the surface tackiness of these packages was checked after the samples were cooled down to ambient temperature after being heated for one minute on the 240°C hot plate. Under these conditions, non-tacky surfaces were observed on all of the formulations. Finally, formulations D, F, G and H were tested using PB8 and TV46ps on Ni/Au finished boards, where PB-8 is a peripheral array flip chip with die size of 200 x 200 mil, 8 mil pitch, 4 mil gap, and 88 I/Os and TV-46 is a full area array micro BGA with die size of 226 x 310 mil, 13 mil gap, and 46 I/Os. Approximately 6 to 14 mg of the samples were dispensed using a syringe onto the substrate. The board was then placed on the pick and place machine manufactured by Universal Instrument and the chips were automatically picked and placed on the board. The entire package was sent to a reflow oven and passed through the standard reflow process where the soaking time is about 2 minutes at 150 °C and the solder fluxing and resin curing time is about 1 minute ramping from 150 °C to 240 °C. This reflow process is to allow the solder bumps to flux and form an interconnect between the chip and board. A 100% interconnection was established with all four formulations using the PB8 chips and formulations F and G obtained a 100% interconnection utilizing the TV46 chips. No residual curing was observed by DSC after the samples went through the reflow process.
EXAMPLE 4: A drop of each of the underfill compositions of Table 3 was placed on a 1" x 3" glass slide. Four 20 mil solder balls were then buried inside each droplet and a 1" x 1" glass slit covered each droplet on the glass slide. The package was heated for two minutes on a 150°C hot plate and then transferred to a 240°C hot plate upon which it was heated for an additional one minute. The package was allowed to cool to ambient temperature. Following the cooling, the package was observed for the presence of any bubbles or void formations. Except for voids trapped in the underfill materials on formulation E, no bubbles or void formations were observed. This illustrates that an epoxy and phenolic resin composition which utilizes an imidazole-anhydride adduct with a fluxing agent will produce an underfill which minimizes voids and bubbles.
EXAMPLE 5: The underfill composition may also be employed in conjunction with lead free solder (Sn 96.5/Ag 3.5, melting point 225 °C). Four underfill compositions were made according to the procedure set out in Example 1. The compositions are set out in Table 5.

**Table 5: Underfill formulations and Viscosity**

| | Epoxy | Phenolic | Corfree M2 | 2P4MZ-PMDA Adduct | DSC (peak°C/ΔH J/g) | Viscosity (cp) |
|---|---|---|---|---|---|---|
| I | Flex-1 74 | HRJ4626 26 | 10 | 3 | 160/160 | 8724 |
| J | Flex-1 66.4 | Dially Bisphenol A 33.6 | 10 | 3 | 173/158 | 3031 |
| K | Flex-1 66.4 | Dially Bisphenol A 33.6 | 10 | 5 | 172/180 | 3440 |
| L | RSL1 739 | Dially Bisphenol A 48 | 10 | 0.5 | 184/234 | 29450 |

The capability of fluxing of these compositions was tested using the hot plate method described in Example 1, except that lead free solder balls and Ni/Au substrate were utilized in place of the tin/lead solder balls and OSP Cu substrate. The fluxing was observed to have an enlargement of 300% of the diameter of the lead free solder ball for each composition tested.

## Claims

1. A no-flow underfill encapsulant material comprising:
a) a thermal curable resin system comprising an admixture of at least one epoxy resin and at least one phenol-containing compound;
b) an imidazole-anhydride adduct; and
c) a fluxing agent.

2. The no-flow underfill encapsulant of claim 1, wherein the at least one epoxy resin is selected from the group comprising monofunctional and multifunctional glycidyl ethers of Bisphenol-A, monofunctional and multifunctional glycidyl ethers of Bisphenol-F, aliphatic epoxies, aromatic epoxies, saturated epoxies, unsaturated epoxies, cycloaliphatic epoxy resins, epoxies having the structures 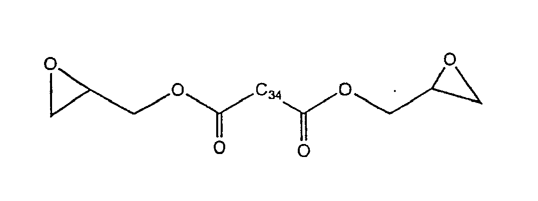 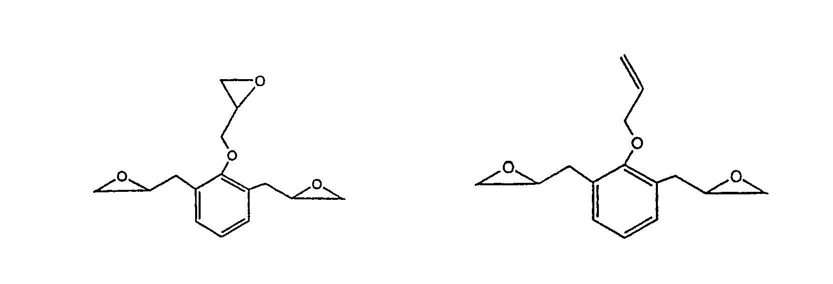 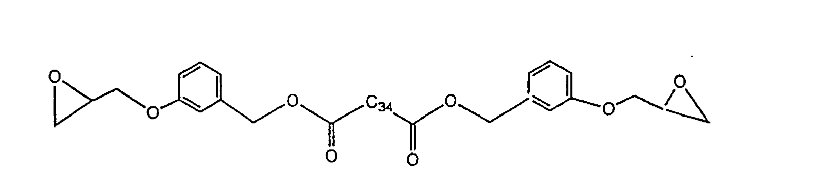 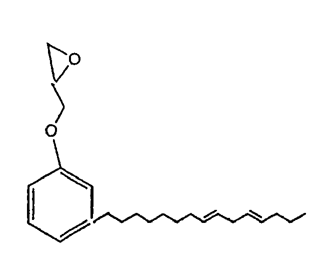 or mixtures thereof.

3. The no-flow underfill encapsulant of claim 2, wherein the at least one epoxy resin is selected from the group consisting of 3,4-epoxycyclohexylmethyl-3,4-epoxycyclohexane carboxylate, vinylcyclohexene dioxide, 3,4-epoxy-6-methyl cyclohexyl methyl-3,4-epoxycyclohexane carboxylate, dicyclopentadiene dioxide, bisphenol A resin, bisphenol F type resin, epoxy novolac resin, poly(phenyl glycidyl ether)-co-formaldehyde, biphenyl type epoxy resin, dicyclopentadiene-phenol epoxy resins, naphthalene epoxy resins, epoxy functional butadiene acrylonitrile copolymers, epoxy functional polydimethyl siloxane, and mixtures thereof.

4. The no-flow underfill encapsulant of claim 1, wherein the phenol-containing compound is selected from the group comprising phenolic resin, phenol or mixtures thereof.

5. The no-flow underfill encapsulant of claim 4, wherein the phenol-containing compound comprises phenolic novalac resin, dially bisphenol-A, bisphenol-A or mixtures thereof.

6. The no-flow underfill encapsulant of claim 3, wherein the at least one epoxy resin comprises in the range of about 0.1 wt % to about 99.9 wt % of the encapsulant.

7. The no-flow underfill encapsulant of claim 4, wherein the epoxy resin comprises in the range of about 40 wt % to about 95 wt % of the encapsulant.

8. The underfill encapsulant of claim 1, wherein the imidazole-anhydride adduct comprise an adduct of imidazole and anhydride selected from the group comprising pyromellitic dianhydride, methylhexa-hydro phthalic anhydride methyltetra-hydrophthalic anhydride, nadic methyl anhydride, hexa-hydro phthalic anhydride, tetra-hydro phthalic anhydride, dodecyl succinic anhydride, phthalic anhydride, bisphenyl dianhydride, benzophenone tetracarboxylic dianhydride, 1-cyanoethyl-2-ethyl-4-methyl-imidazole, alkyl-substituted imidazole, triphenylphosphine, onium borate, non-N-substituted imidazoles, 2-phenyl-4-methyl imidazole, 2-phenyl imidazole, imidazole, N-substituted imidazole and mixtures thereof.

9. The underfill encapsulant of claim 8, wherein the imidazole-anhydride adduct comprise an adduct of 2-phenyl-4-methyl imidazole and pyrometillic dianhydride.

10. The underfill encapsulant of claim 9, wherein the imidazole-anhydride adduct comprises in the range of about 0.01 wt % to about 10 wt % of the encapsulant.

11. The underfill encapsulant of claim 9, wherein the imidazole-anhydride adduct comprises in the range of about 0.1 wt % to about 5 wt % of the encapsulant.

12. The underfill encapsulant of claim 1, wherein the flux component is selected from the group comprising carboxylic acids, rosin gum, dodecanedioic acid, adipic acid, tartaric acid, citric acid, alcohols, H₂O, hydroxyl acid and hydroxyl base, polyols such as ethylene glycol, glyercol, 3-[bis(glycidyl oxy methyl) methoxy]-1,2-propane diol, D-ribose, D-cellobiose, cellulose, 3-cyclohexene-1,1-dimethanol, and mixtures thereof.

13. The underfill encapsulant of claim 12, wherein the flux component comprises rosin gum, dodecanedioic acid, adipic acid, or mixtures thereof.

14. The underfill encapsulant of claim 12, wherein the flux component comprises in the range of about 0.5 wt % to about 20 wt % of the encapsulant.

15. The underfill encapsulant of claim 14, wherein the flux component comprises in the range of about 1 wt % to about 10 wt % of the encapsulant.

16. The underfill encapsulant of claim 1, wherein the encapsulant further comprises one or more of group consisting of surfactants, coupling agents, reactive diluents, air release agents, flow additives, adhesion promoters and mixtures thereof.

17. The underfill encapsulant of claim 16, wherein the surfactant is selected from the group consisting of organic acrylic polymers, silicones, polyoxyethylene/polyoxypropylene block copolymers, ethylene diamine based polyoxyethylene/polyoxypropylene block copolymers, polyol-based polyoxyalkylenes, fatty alcohol-based polyoxyalkylenes, fatty alcohol polyoxyalkylene alkyl ethers and mixtures thereof.

18. The underfill encapsulant of claim 15, wherein the reactive diluent is selected from the group consisting of p-tert-butyl-phenyl-glycidyl ether, allyl glycidyl ether, glycerol diglycidyl ether, glycidyl ether of alkyl, butanediodiglydidylether and mixtures thereof.

## Patentansprüche

1. No-Flow-Underfill-Verkapselungsmaterial, umfassend:
a) ein thermisch härtbares Harzsystem, umfassend ein Gemisch aus wenigstens einem Epoxy-Harz und wenigstens einer Phenol enthaltenden Verbindung;
b) ein Imidazol-Anhydrid-Addukt, und
c) ein Fluxmittel.

2. No-Flow-Underfill-Verkapselungsmaterial nach Anspruch 1, wobei das wenigstens eine Epoxy-Harz ausgewählt ist aus der Gruppe, umfassend monofunktionelle und multifunktionelle Glycidylether von Bisphenol-A, monofunktionelle und multifunktionelle Glycidylether von Bisphenol-F, aliphatische Epoxide, aromatische Epoxide, gesättigte Epoxide, ungesättigter Epoxide, cycloaliphatische Epoxy-Harze, Epoxide mit den Strukturen 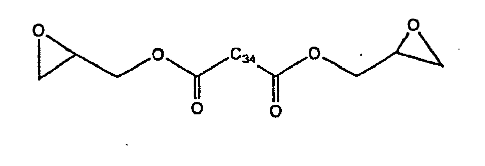 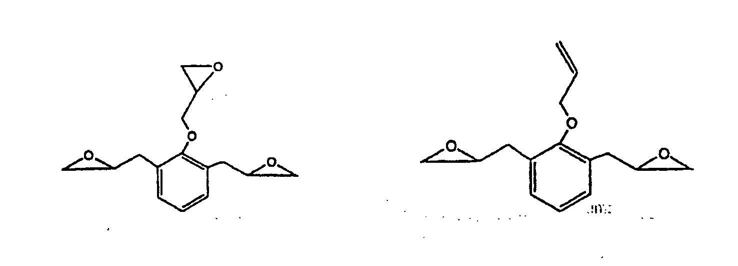 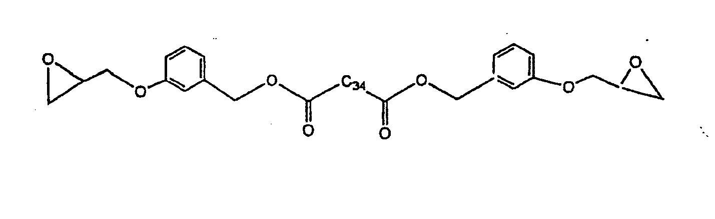 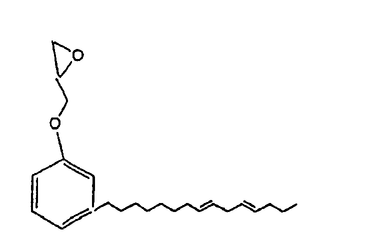 und Gemische davon.

3. No-Flow-Underfill-Verkapselungsmaterial nach Anspruch 2, wobei das wenigstens eine Epoxy-Harz ausgewählt ist aus der Gruppe, bestehend aus 3,4-Epoxycyclohexylmethyl-3,4-epoxycyclohexancarboxylat, Vinylcyclohexendioxid, 3,4-Epoxy-6-methylcyclohexylmethyl-3,4-epoxycyclohexancarboxylat, Dicyclopentadiendioxid, Bisphenol-A-Harz, Bisphenol-F-Harz, Epoxy-Novolak-Harz, Poly(phenylglycidylether)-co-formaldehyd, Epoxy-Harz des Biphenyl-Typs, Dicyclopentadien-Phenol-Epoxy-Harzen, Naphthalin-Epoxy-Harzen, Epoxy-funktionellen Butadien-Acrylnitril-Copolymeren, Epoxy-funktionellen Polydimethylsiloxan und Gemischen davon.

4. No-Flow-Underfill-Verkapselungsmaterial nach Anspruch 1, wobei die Phenol enthaltende Verbindung ausgewählt ist aus der Gruppe, umfassend Phenol-Harz, Phenol und Gemische davon.

5. No-Flow-Underfill-Verkapselungsmaterial nach Anspruch 4, wobei die Phenol enthaltende Verbindung phenolisches Novolak-Harz, Diallylbisphenol-A, Bisphenol-A oder Gemische davon umfasst.

6. No-Flow-Underfill-Verkapselungsmaterial nach Anspruch 3, wobei das wenigstens eine Epoxy-Harz etwa 0,1 Gew.-% bis etwa 99,9 Gew.-% des Verkapselungsmaterials ausmacht.

7. No-Flow-Unterfill-Verkapselungsmaterial nach Anspruch 4, wobei das Epoxy-Harz etwa 40 Gew.-% bis etwa 95 Gew.-% des Verkapselungsmaterials ausmacht.

8. Underfill-Verkapselungsmaterial nach Anspruch 1, wobei das Imidazol-Anhydrid-Addukt ein Addukt von Imidazol und Anhydrid, ausgewählt aus der Gruppe, umfassend Pyromellitsäuredianhydrid, Methylhexahydrophthalsäureanhydrid, Methyltetrahydrophthalsäureanhydrid, Nadinsäuremethylanhydrid, Hexahydrophthalsäureanhydrid, Tetrahydrophthalsäureanhydrid, Dodecylbernsteinsäureanhydrid, Phthalsäureanhydrid, Bisphenyldianhydrid, Benzophenontetracarbonsäuredianhydrid, 1-Cyanoethyl-2-ethyl-4-methylimidazol, alkylsubstituiertes Imidazol, Triphenylphosphin, Oniumborat, nicht-N-substituierte Imidazole, 2-Phenyl-4-methylimidazol, 2-Phenylimidazol, Imidazol, N-substituiertes Imidazol und Gemische davon, umfasst.

9. Underfill-Verkapselungsmaterial nach Anspruch 8, wobei das Imidazol-Anhydrid-Addukt ein Addukt von 2-Phenyl-4-methylimidazol und Pyromellitsäuredianhydrid umfasst.

10. Underfill-Verkapselungsmaterial nach Anspruch 9, wobei das Imidazol-Anhydrid-Addukt etwa 0,01 Gew-% bis etwa 10 Gew.-% des Verkapselungsmaterials ausmacht.

11. Underfill-Verkapselungsmaterial nach Anspruch 9, wobei das Imidazol-Anhydrid-Addukt etwa 0,1 Gew.-% bis etwa 5 Gew.-% des Verkapselungsmaterials ausmacht.

12. Underfill-Verkapselungsmaterial nach Anspruch 1, wobei die Fluxkomponente ausgewählt ist aus der Gruppe, umfassend Carbonsäuren, Kollophoniumgummi, Dodecandisäure, Adipinsäure, Weinsäure, Citronensäure, Alkohole, H₂O, Hydroxysäure und Hydroxylbase, Polyole, zum Beispiel Ethylenglykol, Glycerin, 3-[Bis(glycidyloxymethyl)methoxy]-1,2-propandiol, D-Ribose, D-Cellobiose, Cellulose, 3-Cyclohexen-1,1-dimethanol und Gemische davon.

13. Underfill-Verkapselungsmaterial nach Anspruch 12, wobei die Fluxkomponente Kollophoniumgummi, Dodecandisäure, Adipinsäure oder Gemische davon umfasst.

14. Underfill-Verkapselungsmaterial nach Anspruch 12, wobei die Fluxkomponente etwa 0,5 Gew.-% bis etwa 20 Gew.-% des Verkapselungsmaterials ausmacht.

15. Underfill-Verkapselungsmaterial nach Anspruch 14, wobei die Fluxkomponente etwa 1 Gew.-% bis etwa 10 Gew.-% des Verkapselungsmaterials ausmacht.

16. Underfill-Verkapselungsmaterial nach Anspruch 1, wobei das Verkapselungsmaterial außerdem eines oder mehrere aus der Gruppe, bestehend aus oberflächenaktiven Mitteln, Kopplungsmitteln, reaktiven Verdünnungsmitteln, Luftfreisetzungsmitteln, Fließadditiven, Adhäsionsförderungsmitteln und Gemischen davon, umfasst.

17. Underfill-Verkapselungsmaterial nach Anspruch 16, wobei das oberflächenaktive Material ausgewählt ist aus der Gruppe, bestehend aus organischen Acrylpolymeren, Silikonen, Polyoxyethylen/Polyoxypropylen-Blockcopolymeren, Polyoxyethylen/Polyoxypropylen-Blockcopolymeren auf Ethylendiamin-Basis, Polyoxyalkylenen auf Polyol-Basis, Polyoxyalkylenen auf Fettalkohol-Basis, Fettalkohol-Polyoxyalkylenalkylethern und Gemischen davon.

18. Underfill-Verkapselungsmaterial nach Anspruch 15, wobei das reaktive Verdünnungsmittel ausgewählt ist aus der Gruppe, bestehend aus p-tert-Butyl-phenyl-glycidylether, Allylglycidylether, Glycerindiglycidylether, Alkylglycidylether, Butandiodiglycidylether und Gemischen davon.

## Revendications

1. Matière pour encapsulation sous-jacente sans écoulement, comprenant :
a) un système de résine thermodurcissable comprenant un mélange d'au moins une résine époxy et d'au moins un composé phénolique ;
b) un produit d'addition imidazole-anhydride ; et
c) un agent de fluxage.

2. Matière pour encapsulation sous-jacente sans écoulement suivant la revendication 1, dans laquelle ladite au moins une résine époxy est choisie dans le groupe consistant en des éthers glycidyliques monofonctionnels et multifonctionnels de bisphénol-A, des éthers glycidyliques monofonctionnels et multifonctionnels de bisphénol-F, des résines époxy aliphatiques, des résines époxy aromatiques, des résines époxy saturées, des résines époxy insaturées, des résines époxy cycloaliphatiques, des résines époxy de structures : 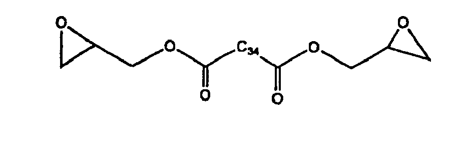 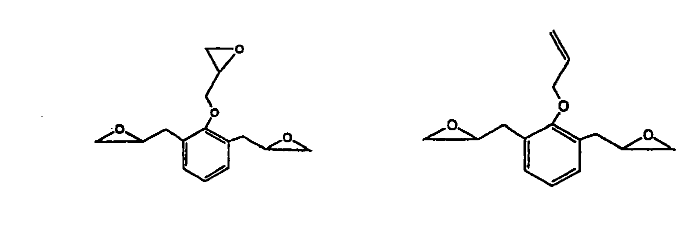 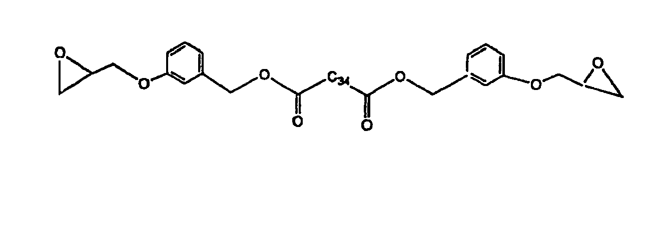 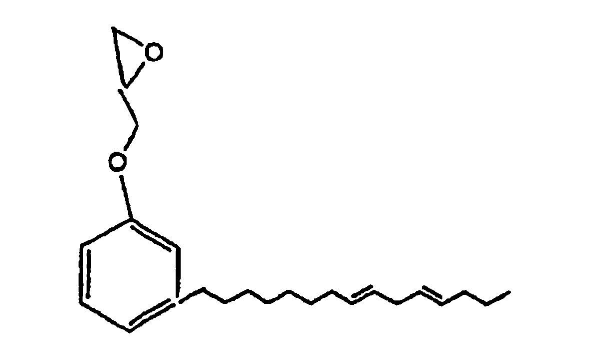 ou leurs mélanges.

3. Matière pour encapsulation sous-jacente sans écoulement suivant la revendication 2, dans laquelle ladite au moins une résine époxy est choisie dans le groupe consistant en le 3,4-époxycyclohexane-carboxylate de 3,4-époxycyclohexylméthyle, le dioxyde de vinylcyclohexène, le 3,4-époxycyclohexane-carboxylate de 3,4-époxy-6-méthylcyclohexylméthyle, le dioxyde de dicyclopentadiène, la résine de bisphénol A, la résine du type bisphénol F, la résine novolaque époxy, le poly(phényl-glycidyl-éther)-co-formaldéhyde, une résine époxy de type biphénylique, des résines époxy de dicyclopentadiène-phénol, des résines époxy de naphtalène, des copolymères butadiène-acrylonitrile à fonctionnalité époxy, le polydiméthylsiloxane à fonctionnalité époxy, et leurs mélanges.

4. Matière pour encapsulation sous-jacente sans écoulement suivant la revendication 1, dans laquelle le composé phénolique est choisi dans le groupe consistant en une résine phénolique, le phénol et leurs mélanges.

5. Matière pour encapsulation sous-jacente sans écoulement suivant la revendication 4, dans laquelle le composé phénolique comprend une résine novolaque phénolique, le diallyl-bisphénol-A, le bisphénol-A ou leurs mélanges.

6. Matière pour encapsulation sous-jacente sans écoulement suivant la revendication 3, dans laquelle ladite au moins une résine époxy comprend environ 0,1 % en poids à environ 99,9 % en poids de la matière d'encapsulation.

7. Matière pour encapsulation sous-jacente sans écoulement suivant la revendication 4, dans laquelle la résine époxy représente environ 40 % en poids à environ 95 % de la matière d'encapsulation.

8. Matière pour encapsulation sous-jacente suivant la revendication 1, dans laquelle le produit d'addition imidazole-anhydride comprend un produit d'addition d'imidazole et d'un anhydride choisi dans le groupe comprenant le dianhydride pyromellitique, l'anhydride méthylhexahydrophtalique, l'anhydride méthyltétrahydrophtalique, l'anhydride méthylnadique, l'anhydride hexahydrophtalique, l'anhydride tétrahydrohydrophtalique, l'anhydride dodécylsuccinique, l'anhydride phtalique, le dianhydride bisphénylique, le dianhydride benzophénonetétracarboxylique, le 1-cyanoéthyl-2-éthyl-4-méthyl-imidazole, un imidazole à substituant alkyle, la triphénylphosphine, un borate d'onium, des imidazoles non N-substitués, le 2-phényl-4-méthylimidazole, le 2-phényl-imidazole, l'imidazole, un imidazole N-substitué, et leurs mélanges.

9. Matière pour encapsulation sous-jacente suivant la revendication 8, dans laquelle le produit d'addition imidazole-anhydride comprend un produit d'addition du 2-phényl-4-méthyl-imidazole et de dianhydride pyromellitique.

10. Matière pour encapsulation sous-jacente suivant la revendication 9, dans laquelle le produit d'addition imidazole-anhydride représente environ 0,01 % en poids à environ 10 % en poids de la matière d'encapsulation.

11. Matière pour encapsulation sous-jacente suivant la revendication 9, dans laquelle le produit d'addition imidazole-anhydride représente environ 0,1 % en poids à environ 5 % en poids de la matière d'encapsulation.

12. Matière pour encapsulation sous-jacente suivant la revendication 1, dans laquelle le constituant fluxant est choisi dans le groupe comprenant des acides carboxyliques, la gomme-résine, l'acide dodécanedioïque, l'acide adipique, l'acide tartrique, l'acide citrique, des alcools, H₂O, un acide hydroxylique et une base hydroxylique, des polyols tels que l'éthylèneglycol, le glycérol, le 3-[bis-(glycidyloxyméthyl)méthoxy]-1,2-propanediol, le D-ribose, le D-cellobiose, la cellulose, le 3-cyclohexène-1,1-diméthanol, et leurs mélanges.

13. Matière pour encapsulation sous-jacente suivant la revendication 12, dans laquelle le constituant fluxant comprend la gomme-résine, l'acide dodécanedioïque, l'acide adipique, ou leurs mélanges.

14. Matière pour encapsulation sous-jacente suivant la revendication 12, dans laquelle le constituant fluxant représente environ 0,5 % en poids à environ 20 % en poids de la matière d'encapsulation.

15. Matière pour encapsulation sous-jacente suivant la revendication 14, dans laquelle le constituant fluxant représente environ 1 % en poids à environ 10 % en poids de la matière d'encapsulation.

16. Matière pour encapsulation sous-jacente suivant la revendication 1, qui comprend en outre un ou plusieurs agents du groupe consistant en des agents tensioactifs, des agents de couplage, des diluants réactifs, des agents de libération d'air, des additifs d'écoulement, des activateurs d'adhérence et leurs mélanges.

17. Matière pour encapsulation sous-jacente suivant la revendication 16, dans laquelle l'agent tensioactif est choisi dans le groupe consistant en des polymères acryliques organiques, des silicones, des copolymères séquencés polyoxyéthylène/polyoxypropylène, des copolymères séquencés polyoxyéthylène/polyoxypropylène à base d'éthylènediamine, des polyoxyalkylènes à base de polyols, des polyalkylènes à base d'alcools gras, des éthers alkyliques de polyoxyalkylènes d'alcools gras et leurs mélanges.

18. Matière pour encapsulation sous-jacente suivant la revendication 15, dans laquelle le diluant réactif est choisi dans le groupe consistant en l'éther de p-tertio-butylphénylglycidyle, l'éther glycidylique d'allyle, l'éther diglycidylique de glycérol, l'éther glycidylique d'alkyle, l'éther diglycidylique de butanediol et leurs mélanges.
